# EUROPEAN PATENT SPECIFICATION

(11) **EP 0 351 157 B1**
(45) Date of publication and mention of the grant of the patent: **22.11.1995**
(21) Application number: 89306965.8
(22) Date of filing: 10.07.1989
(51) Int. Cl.: G06F 13/14, H03K 17/22

(54) **Semiconductor integrated circuits**
Integrierte Halbleiterschaltungen
Circuits intégrés à semi-conducteurs

(30) Priority: 12.07.1988 JP 172889/88; 19.07.1988 JP 179746/88
(43) Date of publication of application: 17.01.1990
(73) Proprietor: SONY CORPORATION, Tokyo 141 (JP)
(72) Inventor: Maeda, Shyunji c/o Patents Division, Shinagawa-ku Tokyo 141 (JP); Wakamatsu, Masataka c/o Patents Division, Shinagawa-ku Tokyo 141 (JP)
(74) Representative: Cotter, Ivan John

(56) References cited:
- EP-A- 0 086 671
- EP-A- 0 096 531
- EP-A- 0 173 769
- US-A- 4 244 018
- US-A- 4 403 192
- IBM TECHNICAL DISCLOSURE BULLETIN, vol. 30, no.8, January 1988, pages 367369, New York, US; "Priority controller for bus arbiter"
- PROCEEDINGS OF THE NATIONAL COMPUTER CONFERENCE, New York, 7-10 June 1976, Pages 777-782, Montvale, US, H. SECHOVSKY et al. : "Asynchronous speed-independent arbiter in a form of a hardware control module"
- PATENT ABSTRACTS OF JAPAN, vol. 10, no.54 (E-385)(2111), 4 March 1986;

## Description

This invention relates to semiconductor integrated circuits (ICs).

It is known for a semiconductor IC to include a sequence circuit, such as a shift register circuit, an arbitration circuit or a flip-flop circuit, whose output is not determined merely by the present input alone, but is dependent also on past hysteresis. A preferred aspect of the invention described in detail below relates to an arbitration circuit included in a semiconductor IC for sequentially giving proper priority to a plurality of request signals upon occurrence of competitive inputs of various request signals, such as access requests, refresh requests and so forth.

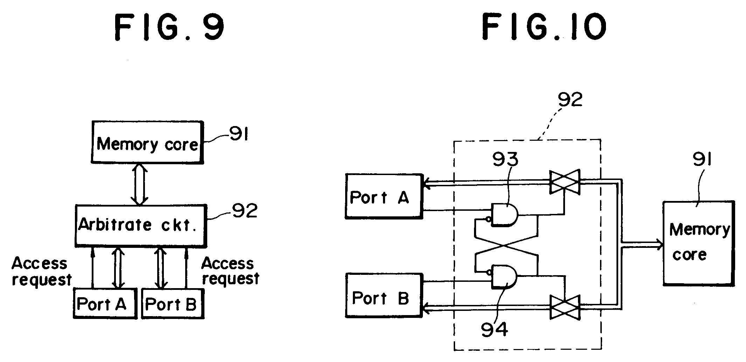

Figure 9 of the accompanying drawings shows a previously proposed semiconductor memory unit having two ports A and B. The memory unit includes a memory core 91 and is accessible selectively after access requests are outputted respectively from the ports A and B. When a coincidence in timing happens to occur between such access requests, an arbitration (arbitrate) circuit 92 gives priority to one access request while suspending the other.

Figure 10 of the accompanying drawings shows how the arbitration circuit 92 may be constructed. The circuit 92 comprises two 2-input AND circuits 93 and 94. An output signal of each of the AND circuits 93 and 94 is inverted and fed to one input of the other AND circuit, the other inputs of the AND circuits receive the access requests from the ports A and B, respectively, and the output signals of the individual AND circuits control transfer between the ports A, B and the memory core 91.

The operation of the arbitration circuit 92 will now be described briefly. It is assumed that, initially, neither of the two ports A and B is outputting an access request and both the inputs and outputs of the AND circuits 93 and 94 are at a low (L) level. When an access request is received from the port A, the input of the AND circuit 93 is switched to a high (H) level so that the output thereof is changed to a high level. As a result, signal transfer between the port A and the memory core 91 is rendered possible. Meanwhile, the output of the AND circuit 93 is inverted and fed to the AND circuit 94. Therefore, the output of the AND circuit 94 is switched to a low level, and is kept in such a state despite the arrival of any access request from the port B. That is, the access request from the port B is not accepted unless the preceding access request from the port A is halted.

Although the above-described arbitration circuit 92 has two ports, recent further diversity of memory units tends to necessitate enhanced arbitration of request signals from three or more ports.

However, where gate circuits are arranged in parallel in correspondence with the number of ports and any other gate circuits are merely closed in response to arrival of a signal from one port, a problem arises upon occurrence of competitive inputs of second, third and following access requests. Suppose in this regard that, during the execution of an access operation according to a first access request received from one port, a next or second access request is inputted and, further, a third access request is received. Then, since no priority order is established with regard to the second and third access request signals, a competitive process occurs at the completion of the first access operation, giving rise eventually to failure to achieve desired arbitration of such signals.

In a semiconductor integrated circuit (IC) including a sequence circuit such as an arbitration circuit for sequentially giving proper priority to a plurality of request signals upon occurrence of competitive inputs of such signals, one aspect of the invention resides in the provision of gate circuits arrayed in the form of a matrix with N rows and N-1 columns, gate closing circuits for closing the gate circuits in the other rows and the same column, gate opening circuits for opening the closed gate circuits in the other rows and the preceding column, and gate holding circuits for holding the signals to the gate circuits in the same row and the previous columns, thereby processing three or more request signals in sequence.

According to a further aspect of the invention there is provided an arbitration circuit, included in a semiconductor integrated circuit, for sequentially giving proper priority to a plurality of request signals upon occurrence of competitive inputs of such request signals to N input terminals (where N is a natural number equal to or greater than 3), the arbitration circuit comprising:
N input terminals;
N output terminals;
gate circuits arrayed to form a matrix with N rows and N-1 columns in such a manner that N-1 gate circuits are connected in series between the N input and output terminals, respectively;
gate holding circuits arranged to be driven in response to passage of a signal through any one gate circuit and operative to hold, until completion of inputting of said signal to said gate circuit, the other signals to the gate circuits in the same row and the previous column(s);
gate closing circuits arranged to be driven in response to passage of a signal through any one gate circuit and operative to close, until completion of inputting of said signal to said gate circuit, the gate circuits in the other rows and the same column except the gate circuit(s) where the signal is held by the gate holding circuit(s); and
gate opening circuits arranged to be driven in response to passage of a signal through any one gate circuit and operative to open the closed gate circuits in the other rows and the preceding column.

Preferred embodiments of the invention described below provide an improved arbitration circuit which is capable of performing proper arbitration of three or more request signals.

The invention will now be further described, by way of illustrative and non-limiting example, with reference to the accompanying drawings, in which:
Figure 1 schematically shows an exemplary gate array in a general form of arbitration circuit embodying the invention;
Figure 2 schematically illustrates the function of gate closing circuits in the arbitration circuit;
Figure 3 schematically illustrates the function of gate opening circuits in the arbitration circuit;
Figure 4 schematically illustrates the function of gate holding circuits in the arbitration circuit;
Figure 5 is a circuit diagram of an arbitration circuit according to a first embodiment of the invention;
Figure 6 is a timing chart of signals for explaining the operation of the arbitration circuit of Figure 5;
Figure 7 is a block diagram of an exemplary system employing an arbitration circuit embodying the invention;
Figure 8 is a circuit diagram of an arbitration circuit according to a second embodiment of the invention;
Figure 9 is a block diagram of a system incorporating an arbitration circuit; and
Figure 10 is a block diagram of a previously proposed arbitration circuit.

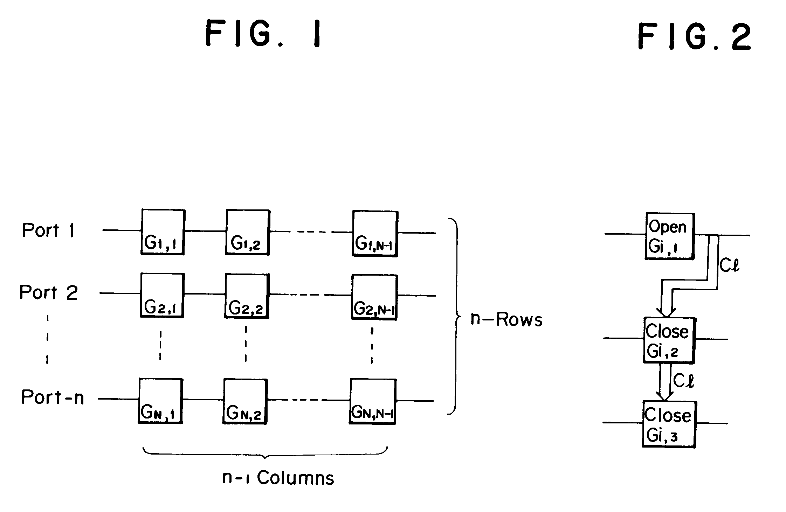

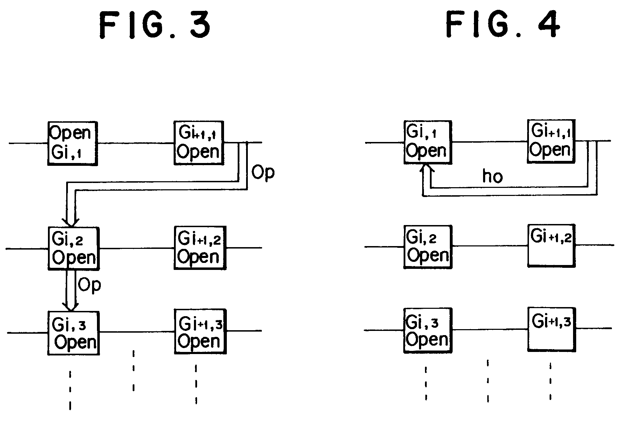

A general form of arbitration circuit embodying the invention will now be described with reference to Figures 1 to 4 which schematically illustrate the circuit. In the arbitration circuit, gate circuits G_{i,j} (i = a natural number from 1 to N; j = a natural number from 1 to N-1) are arrayed in the form of a matrix with N rows and N-1 columns as shown in Figure 1, wherein N-1 gate circuits are connected in series between N (=a natural number greater than 3) input terminals and N output terminals. As shown in Figures 2 to 4, gate closing circuits Cl, gate opening circuits Op and gate holding circuits Ho are connected to the gate circuits. As shown in Figure 2, the gate closing circuits Cl are driven in response to passage of a signal through any one gate circuit and close the gate circuits in the other rows and the same column. Although the gate closing circuits Cl thus function to close the gate circuits in the other rows and the same column, such closing operation is not performed for the row being held by the gate holding circuits Ho. And the closing operation is maintained until completion of input of the signal (e.g. until halting of the process request). As shown in Figure 3, the gate opening circuits Op are driven in response to passage of a signal through any one gate circuit and function to open the closed gate circuits in the other rows and the preceding column. (The preceding column signifies the column immediately before the aforesaid one gate circuit.) Furthermore, as shown in Figure 4, the gate holding circuits Ho are driven in response to passage of a signal through any one gate circuit and function to hold the other signals to the gate circuits in the same row and the previous columns. (The previous columns signify those from the first column to the preceding column.) The gate holding circuits Ho perform the operation to cope with the gate closing operation and may be provided for the individual columns. Such holding operation is maintained continuously until completion of inputting of a signal.

The arbitration circuit comprises gate circuits arranged in N rows each composed of series-connected N-1 gate circuits, wherein a received signal is outputted after successive passage through the entirety of the series-connected N-1 gate circuits. During the signal passage through each gate circuit, the gate circuits in the other rows and the same column are closed by the gate closing circuits and, simultaneously, the gate circuits in the other rows and the preceding column are opened from the closed state by the gate opening circuits. Consequently, upon complete passage of the signal through the gate circuit in the (i)th row and the (j)th column, the gate circuits in any other rows than the (i)th rows and in the (j)th column are closed, while the gate circuits in any other rows than the (i)th row and in the (j-1)th column are opened. The signal thus passed through the gate circuit in the (i)th row and the (j)th column is then forwarded to the next gate circuit in the (i)th row and the (j+1)th column. If the gate circuit in the (i)th row and the (j+1)th column has already been closed by the preceding input signal, the present input signal is brought to a halt in the state where the gate circuits in any other rows than the (i)th row and in the (j)th column are closed, and the signal is not forwarded any further than the gate circuit in the above column. And, after completion of the preceding input signal, the gate circuit in the (i)th row and the (j+1)th column is opened from the closed state to permit advance of the request signal to the (j+1)th column.

The gate holding circuit serves to protect the input signal previously from closure of the gate circuit, so that the gate circuit in the row relevant to the preceding signal is not closed by any of the following input signals. Thus, when the input and output terminals are concerned with N rows, required N-1 data are sufficient to determine the priority order. Therefore, in a construction where the gate circuits are arranged in the form of a matrix consisting of N rows and N-1 columns, each of the N-1 columns has information relative to the order of input signals, and the priority order of the second and the following is determined by the condition that the signal of each row is in which of the columns.

Preferred embodiments of the invention will now be described.

### First Embodiment

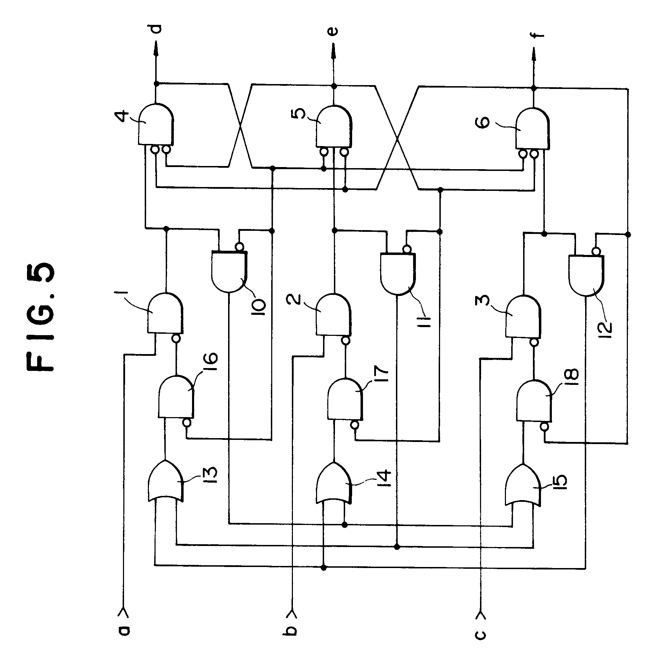

A first exemplary arbitration circuit embodying the invention is constructed as shown in Figure 5, wherein gate circuits are arrayed in the form of a matrix consisting of 3 rows and 2 columns (N = 3) to arbitrate access requests from ports of three systems.

The circuit configuration will be explained first. As shown in Figure 5, gate circuits 1 and 4 are connected in series between an input terminal a and an output terminal d, gate circuits 2 and 5 are connected in series between an input terminal b and an output terminal e, and gate circuits 3 and 6 are connected in series between an input terminal c and an output terminal f. The gate circuits 1, 2 and 3 constitute a first column and the gate circuits 4, 5 and 6 constitute a second column. The gate circuits 1 to 6 are AND circuits of which the input terminals not connected in series with one another are inverse input terminals.

Relative to the gate circuits 1 to 6 arrayed to form a 3-row, 2-column matrix, gate closing circuits are provided for feeding back the outputs of the relevant gate circuits and thereby closing the gate circuits in the other rows and the same column. In this embodiment, two-input OR circuits 13, 14, 15 function as gate closing circuits for the gate circuits 1, 2, 3, respectively. The individual two inputs of the OR circuits 13, 14, 15 are obtained via AND circuits 10, 11, 12, which function as gate opening circuits as will be described later, from the outputs in the other rows and the same column. That is: the OR circuit 13 receives the outputs of the gate circuits 2 and 3; the OR circuit 14 receives the outputs of the gate circuits 1 and 3; and the OR circuit 15 receives the outputs of the gate circuits 1 and 2. Due to such connection, when the output of any one gate circuit is at a high (H) level, the related closing circuit functions to close the gate circuits in the same column and the other rows. The terminals of the gate circuits 1, 2, 3 for receiving signals from the OR circuits 13, 14, 15, respectively, are inverse input terminals connected thereto via AND circuits 16, 17, 18. Although depending on another input level also, the gate circuit 1 is closed when the output of the OR circuit 13 is switched to a high level; the gate circuit 2 is closed when the output of the OR circuit 14 is switched is switched to a high level; and the gate circuit 3 is closed when the output of the OR circuit 15 is switched to a high level.

The gate circuits 4 to 6 are equivalent to the gate circuits 1 to 3 with the exception of the AND circuits 10 to 12 and 16 to 18 connected thereto. In the gate circuits 4 to 6, inverted inputs are fed to the terminals thereof except those connected in series with one another, and such inverted inputs are the outputs from the other rows and the same column. Therefore: the gate circuits 5 and 6 are closed when the output of the gate circuit 4 is switched to a high level; the gate circuits 4 and 6 are closed when the output of the gate circuit 5 is switched to a high level; and the gate circuits 4 and 5 are closed when the output of the gate circuit 6 is switched to a high level. Since this column is the final stage, it is not affected by the next column. Consequently, there is no need to provide any gate opening circuits or gate holding circuits such as the AND circuits 10 to 12 or 16 to 18.

The gate opening circuits operate in response to passage of a signal through any one gate circuit and open the closed gate circuits in the other rows and the preceding column. In this embodiment, the AND circuits 10 to 12 have such function. The AND circuits 10 to 12 are interposed between the respective input terminals of the gate closing circuits so as to serve as switches. The output of the gate circuit 4 is fed back to the AND circuit 10; the output of the gate circuit 5 is fed back to the AND circuit 11; and the output of the gate circuit 6 is fed back to the AND circuit 12. For example, when the output of the gate circuit 4 is switched to a high level, it is inversely inputted to the AND circuit 10. Therefore, the output of the AND circuit 10 is switched to a low level, and such low-level signal is then supplied to the OR circuits 14 and 15 so as consequently to open the closed gate circuits 2 and 3. The above operation is performed similarly with regard to the AND circuits 11 and 12 as well.

The gate holding circuits operate in response to passage of a signal through any one gate circuit and hold other signals to the other gate circuits in the same row and the preceding column until completion of inputting of the first signal. More specifically, at the signal input time, the signals from the gate closing circuits 13 to 15 are interrupted by means of the AND circuits 16 to 18. Both the output of the OR circuit 13 and the inverted output of the gate circuit 4 are fed to the AND circuit 16, whose output is then inverted and fed to the gate circuit 1. The output of the OR circuit 14 and the inverted output of the gate circuit 5 are fed to the AND circuit 17, whose output is then inverted and fed to the gate circuit 2. Meanwhile, the output of the OR circuit 15 and the inverted output of the gate circuit 6 are fed to the AND circuit 18, whose output is then inverted and fed to the gate circuit 3. Due to such connection relationship, the output of the OR circuit 13 is interrupted by the AND circuit 16 when the output of the gate circuit 4 is switched to a high level, so that the gate circuit 1 is not put into its closed state despite input of a second signal to any other row.

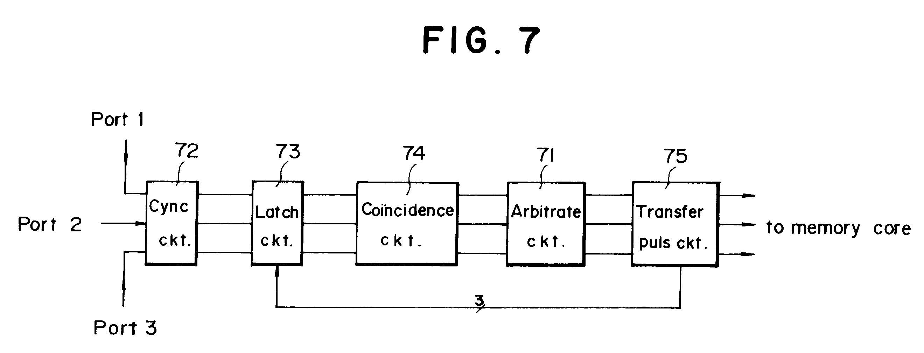

The arbitration circuit of the construction described above may be employed as a component of, for example, a memory unit shown in Figure 7. The circuit configuration of Figure 7 is designed for arbitrating between access requests from three input/output ports (ports 1 to 3) to a memory core. The access request signals received from the three ports are inputted to a synchronising circuit 72, where each of the access request signals is synchronised with the period of clock pulses by a flip-flop or the like. Subsequently, the access request signals are fed to a latch circuit 73. In this example, the latch circuit consists of a J-K flip-flop whose K terminal receives the signal from the synchronising circuit 72 and whose J terminal receives a signal from a transfer pulse circuit 75. Therefore, the latch circuit 73 is initialised after generation of a transfer pulse. An output of the latch circuit 73 is fed to a coincidence circuit 74, which may be so formed as to cause slight mutual delays among three signal lines in case the pulses are inputted at the same timing to such signal lines. For example, if the signal from the port 1 is not delayed, the signals from the ports 2 and 3 are delayed for 1/3 and 2/3 of a clock period, respectively. Thus, it becomes possible to prevent pulses from the three signal lines being fed to an arbitration circuit 71 at exactly the same timing. When competitive inputs of access requests from the individual ports occur, the arbitration circuit 71 is capable of sequentially giving priority to the access requests to achieve successive accesses, as will be described later. An exemplary form of construction of the arbitration circuit 71 is shown in Figure 5. The access request signals, thus arbitrated, are fed to the transfer pulse circuit 75, which then produces output signals to control transfer gates between the memory core and the individual ports. For example, when one of the output signals of the transfer pulse circuit 75 is switched to a high level, signal transfer is rendered possible between the memory core and the port relevant to such signal.

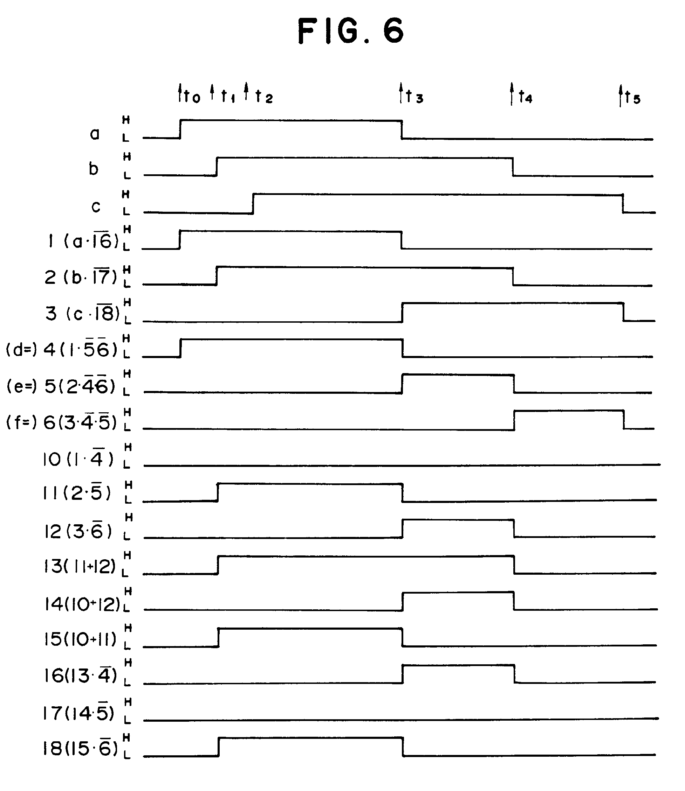

The operation of the arbitration circuit described with reference to Figures 5 and 7 will now be described with reference to Figure 6.

It is assumed that the input terminals a, b and c shown in Figure 5 are connected to the coincidence circuit 74 shown in Figure 7, and that the output terminals d, e and f shown in Figure 5 are connected to the transfer pulse circuit 75 shown in Figure 7. It is also assumed that the entirety of the gates of the arbitration circuit are in a low-level state. Assume now that access requests are received from the three ports exactly simultaneously. Then, the three access signals are synchronised with the clock period by the synchronising circuit 72 and are fed simultaneously to the coincidence circuit 74 via the latch circuit 73. In the coincidence circuit 74, no delay is applied to the signal to be supplied to the terminal a, a 1/3 clock period delay is applied to the signal to be supplied to the terminal b, and a 2/3 clock period delay is applied to the signal to be supplied to the terminal c.

Figure 6 is a timing chart of the input signals. In the arbitration circuit, the signal at the terminal a is changed from a low level to a high level at an instant t0. As a result, the output of the gate circuit 1 is switched to a high level so that the output of the gate circuit 4 is also switched to a high level. Consequently, first the signal at the terminal d is switched to a high level and is outputted as an access request from the arbitration circuit. During such process, the output of the gate circuit 1 is switched to a high level so that, in the first column, the gate circuits 2 and 3 are closed via the AND circuit 10 and the OR circuits 14, 15 merely for an extremely short time and then are opened immediately by the feedback output of the gate circuit 4. Meanwhile, as the output of the gate circuit 4 is switched to a high level, the inverse inputs of the gate circuits 5, 6 are at a high level so as consequently to put the gate circuits 5, 6 in a closed state. Furthermore, the signal from the gate circuit 4 is also inverted and fed to the AND circuit 16 whose output remains unchanged at a low level, so that the output of the gate circuit 1 is not inverted, despite inversion of the output of the OR circuit 13.

At a later instant t1, after the lapse of a 1/3 clock period delay, the access request from the other port is inputted to the terminal b. Since the gate circuit 2 has already been opened at this instant, the output of the gate circuit 2 is switched to a high level. However, the output of the gate circuit 5 is not switched to a high level because it is closed by the signal from the gate circuit 4. That is, there occurs a state in which the access request signal is halted in the preceding column. When the signal from the gate circuit 2 is switched to a high level, the output of the AND circuit 11 is also changed to a high level so as consequently to switch the outputs of the OR circuits 13 and 15 to a high level. The output of the OR circuit 13 closes the gate circuit 1 via the AND circuit 16, but in this stage the output of the AND circuit 16 has already been set to a low level by the signal from the gate circuit 4, whereby the high-level signal from the OR circuit 13 is not permitted to reach the gate circuit 1. Meanwhile, the high-level output of the OR circuit 15 is fed to the gate circuit 3 via the AND circuit 18, thereby closing the gate circuit 3.

Subsequently, a high-level signal is fed to the terminal c at an instant t2. However, since the gate circuit 3 has already been closed at the instant t1, no change is caused in the gate circuit, despite any high-level input to the terminal c.

Assume now that, at a later instant t3, the signal to the terminal a is switched from a high level to a low level. Then, the output of the gate circuit 1 is changed from a high level to a low level and, similarly, the output of the gate circuit 4 is also changed to a low level. Due to such change of the output of the gate circuit 4 to a low level, the output of the AND circuit 16 is switched to a high level so as consequently to close the gate circuit 1. Meanwhile, the gate circuits 5 and 6 are opened from the closed state and, since the output of the gate circuit 2 has already been switched to a high level, first the output of the gate circuit 5 is switched to a high level. It follows therefore that the access request signal from the next port is outputted from the terminal e. The gate circuits 4 and 6 are closed in accordance with the change of the output of the gate circuit 5 to a high level. Also, the output of the AND circuit 11 is switched to a low level due to such change of the output of the gate circuit 5 to a high level. In this stage of the operation, the output of the AND circuit 17 remains at a low level. And, since the outputs of the AND circuits 10 and 11 are both at a low level, the output of the OR circuit 15 becomes of low level. As a result, the output of the AND circuit 18 is changed from a high level to a low level so as consequently to open the gate circuit 3 from the closed state. Accordingly, the output of the gate circuit 3 is switched to a high level while the output of the AND circuit 12 is changed from a low level to a high level, so that the outputs of the OR circuits 13 and 14 are also changed to a high level (with the output of the OR circuit 13 remaining at a high level). In a state immediately after the instant t3, the access request from the terminal c is kept waiting in the first-row gate circuit differently from the preceding state.

The access request signal inputted to the terminal b is completed at a later instant t4. As a result, the outputs of the gate circuits 2 and 5 are switched to a low level so as consequently to open the gate circuits 4 and 6. Then, since the output of the gate circuit 3 has already been switched to a high level, the output of the gate circuit 6 is changed from a low level to a high level, whereby the gate circuits 4 and 5 are put into a closed state. In this stage, the signal from the terminal f is switched to a high level so that a transfer pulse is generated on the basis of the access request inputted to the third port. Meanwhile, the output of the AND circuit 12 is changed from a high level to a low level. As a result, the outputs of the OR circuits 13 and 14 are both changed from a high level to a low level, and also the output of the OR circuit 16 is changed to a low level. Such change of the outputs of the OR circuits 13 and 14 to a low level signifies that the gate circuits 1 and 2, formerly in the closed state, are opened, whereby each of the terminals a and b is rendered ready to receive the next access request signal.

At an instant t5, the signal from the terminal c is switched to a low level so as consequently to change the outputs of the gate circuits 3 and 6 to a low level. Since any successive access request signal is not inputted, the gate circuits are placed in a standby state to wait for arrival of further access request signals.

Thus, in the above-described arbitration circuit, proper priority is given sequentially to each of the first, second and third input access request signals with certainty so as eventually to enable accurate transfer of the signals between the ports and the memory core.

### Second Embodiment

A second exemplary arbitration circuit embodying the invention comprises a 4-row, 3-column gate array and is capable of arbitrating between access requests from, for example, four ports. This example is accomplished by modifying the construction of the above-described first embodiment to form a gate array with 4 rows and 3 columns.

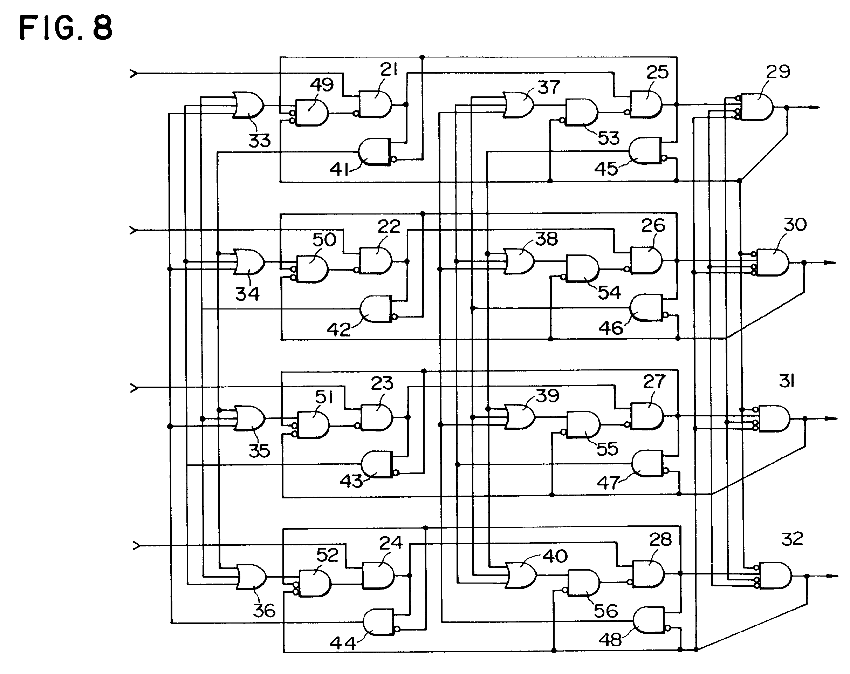

The construction of the second embodiment will now be described with reference to Figure 8. Gate circuits 21 to 32 are arrayed in the form of a matrix with 4 rows and 3 columns. The first row consists of gate circuits 21, 25, 29; the second row consists of gate circuits 22, 26, 30; the third row consists of gate circuits 23, 27, 31; and the fourth row consists of gate circuits 24, 28, 32. Gate closing circuits comprise OR circuits 33 to 40, a circuit arrangement for feeding inverted signals to the gate circuits 29 to 32 in the third column, and wiring to the gate circuits 21 to 32 in the other rows and the same column. Gate opening circuits principally comprise AND circuits 41 to 48; and gate holding circuits principally comprise AND circuits 49 to 56. Each of the AND circuits 49 to 52 has two inverse input terminals and is capable of holding an access request signal even when such signal is existent in the second column as well as in the first column. The connection relationship is similar to that of the above-described first embodiment, but the number of connecting wires required for the gate opening circuits becomes greater due to the 4-row, 3-column array.

In the second embodiment, desired arbitration is possible with respect to 4-row parallel pulse inputs, and proper priority can be given sequentially to second to fourth access requests.

The first and second embodiments of the invention have been described above, by way of example, as comprising 3-row, 2-column and 4-row, 3-column gate arrays, respectively. However, it is to be understood that each of such examples is extendable to an array with N rows and N-1 columns (where N is a natural number equal to or greater than 3). Furthermore, the invention is applicable not only to access requests in a memory unit, but also to refresh requests and so forth. In addition, it is possible to apply the invention to a time sharing system (TSS) employed in a large-sized computer or the like. Although the arbitration circuit is formed principally in a chip, it may be used as a component of a system outside of a chip.

The arbitration circuits described above comprise a gate array of N rows and N-1 columns with gate closing circuits, gate opening circuits and gate holding circuits, so that proper priority can be given sequentially to signals upon occurrence of three or more competitive signal processing requests, hence achieving satisfactory arbitration of competitive signal inputs with certainty.

## Claims

1. An arbitration circuit, included in a semiconductor integrated circuit, for sequentially giving proper priority to a plurality of request signals upon occurrence of competitive inputs of such request signals to N input terminals (where N is a natural number equal to or greater than 3), the arbitration circuit comprising:
N input terminals;
N output terminals;
gate circuits (1-6; 21-32) arrayed to form a matrix with N rows and N-1 columns in such a manner that N-1 gate circuits are connected in series between the N input and output terminals, respectively;
gate holding circuits (16-18; 49-56) arranged to be driven in response to passage of a signal through any one gate circuit and operative to hold, until completion of inputting of said signal to said gate circuit, the other signals to the gate circuits in the same row and the previous column(s);
gate closing circuits (13-15; 33-40) arranged to be driven in response to passage of a signal through any one gate circuit and operative to close, until completion of inputting of said signal to said gate circuit, the gate circuits in the other rows and the same column except the gate circuit(s) where the signal is held by the gate holding circuit(s); and
gate opening circuits (10-12; 41-48) arranged to be driven in response to passage of a signal through any one gate circuit and operative to open the closed gate circuits in the other rows and the preceding column.

2. An arbitration circuit according to claim 1, comprising three input terminals (a-c), three output terminals (d-f), and gate circuits (1-6) arrayed to form a matrix with three rows and two columns.

3. An arbitration circuit according to claim 1 or claim 2, wherein the gate circuits (1-6; 21-32), the gate opening circuits (10-12; 41-48)and the gate holding circuits (16-18; 49-56) comprise AND circuits, and the gate closing circuits (13-15; 33-40) comprise OR circuits.

4. An arbitration circuit according to claim 2, wherein:
first and fourth said gate circuits (1, 4) are connected in series between a first said input terminal (a) and a first said output terminal (d);
second and fifth said gate circuits (2, 5) are connected in series between a second said input terminal (b) and a second said output terminal (e);
third and sixth said gate circuits (3, 6) are connected in series between a third said input terminal (c) and a third said output terminal (f);
the first to sixth gate circuits (1-6) comprise AND circuits whose input terminals not connected in series with one another are inverse input terminals;
the gate closing circuits for the first to third gate circuits (1, 2, 3) comprise first to third OR circuits (13, 14, 15) so arranged as to receive outputs of the second and third gate circuits (2, 3), outputs of the first and third gate circuits (1, 3), and outputs of the first and second gate circuits (1, 2), respectively;
the gate opening circuits for the first to third gate circuits (1, 2, 3) comprise first to third AND circuits (10, 11, 12) so arranged as to individually receive the outputs of the fourth to sixth gate circuits (4, 5, 6) fed back thereto, respectively;
the gate holding circuits for the first to third gate circuits (1, 2, 3) comprise fourth to sixth AND circuits (16, 17, 18) operative to interrupt, at the signal input time, signals from the first to third OR circuits (13, 14, 15) respectively;
an output of the first OR circuit (13) and an inverted output of the fourth gate circuit (4) are fed to the fourth AND circuit (16), an output of which is inverted and fed to the first gate circuit (1);
an output of the second OR circuit (14) and an inverted output of the fifth gate circuit (5) are fed to the fifth AND circuit (17), an output of which is inverted and fed to the second gate circuit (2);
an output of the third OR circuit (15) and an inverted output of the sixth gate circuit (6) are fed to the sixth AND circuit (18), an output of which is inverted and fed to the third gate circuit (3);
the fourth to sixth gate circuits (4, 5, 6) are so arranged that inverted inputs are fed to the input terminals thereof except those connected in series with one another, and such inverted inputs are outputs from the other rows and the same column; and
input terminals of the first to third gate circuits (1, 2, 3) for receiving the signals, respectively, from the first to third OR circuits (13, 14, 15) are inverse input terminals connected thereto via the fourth to sixth AND circuits (16, 17, 18).

## Patentansprüche

1. In einer integrierten Halbleiterschaltung enthaltene Entscheidungsschaltung zur sequentiellen Zuteilung einer geeigneten Priorität an eine Mehrzahl von Anforderungssignalen beim Auftreten von konkurrierenden Eingängen derartiger Anforderungssignale an N Eingangsanschlüssen (worin N eine natürliche Zahl und größer als 3 ist), wobei die Entscheiderschaltung aufweist:
N Eingangsanschlüsse,
N Ausgangsanschlüsse,
Gatterschaltungen (1 bis 6; 21 bis 32), die arrayartig in einer Matrix mit N Zeilen und (N-1) Spalten so angeordnet sind, daß jeweils (N-1) Gatterschaltungen in Reihenschaltung zwischen den Eingangsanschlüssen und den Ausgangsanschlüssen angeordnet sind,
Gatter-Halteschaltungen (16 bis 18; 49 bis 56), die so angeordnet sind, daß sie als Reaktion auf den Durchgang eines Signals durch eine der Gatterschaltungen betätigt werden, um bis zur Beendigung der Eingabe des genannten Signals in die genannte Gatterschaltung die anderen Signale an den anderen Gatterschaltungen in derselben Zeile und in der (den) vorhergehenden Spalte(n) zu halten,
Gatter-Sperrschaltungen (13 bis 15; 33 bis 40), die so angeordnet sind, daß sie als Reaktion auf den Durchgang eines Signals durch eine der Gatterschaltungen betätigt werden, um bis zur Beendigung der Eingabe des genannten Signals in die genannte Gatterschaltung die Gatterschaltungen in den anderen Zeilen und in derselben Spalte zu sperren, mit Ausnahme der Gatterschaltung(en), in denen das Signal von der (den) Gatter-Halteschaltung(en) gehalten wird,
Gatter-Öffnungsschaltungen (10 bis 12; 41 bis 48), die so angeordnet sind, daß sie als Reaktion auf den Durchgang eines Signals durch eine der Gatterschaltungen betätigt werden, um die gesperrten Gatterschaltungen in den anderen Zeilen und in der vorhergehenden Spalte zu öffnen.

2. Entscheidungsschaltung nach Anspruch 1 mit drei Eingangsanschlüssen (a bis c), drei Ausgangsanschlüssen (d bis f) und Gatterschaltungen (1 bis 6), die arrayartig in einer Matrix mit drei Zeilen und zwei Spalten angeordnet sind.

3. Entscheidungsschaltung nach Anspruch 1 oder 2, bei der die Gatterschaltungen (1 bis 6; 21 bis 32), die Gatter-Öffnungsschaltungen (10 bis 12; 41 bis 48) und die Gatter-Halteschaltungen (16 bis 18; 49 bis 56) UND-Glieder und die Gatter-Sperrschaltungen (13 bis 15; 33 bis 40) ODER-Glieder enthalten.

4. Entscheidungsschaltung nach Anspruch 2, bei der
eine erste und eine vierte Gatterschaltung (1, 4) in Reihe zwischen einem ersten Eingangsanschluß (a) und einem ersten Ausgangsanschluß (d) angeordnet sind,
eine zweite und eine fünfte Gatterschaltung (2, 5) in Reihe zwischen einem zweiten Eingangsanschluß (b) und einem zweiten Ausgangsanschluß (e) angeordnet sind,
eine dritte und eine sechste Gatterschaltung (3, 6) in Reihe zwischen einem dritten Eingangsanschluß (c) und einem dritten Ausgangsanschluß (f) angeordnet sind,
die erste bis sechste Gatterschaltung (1 bis 6) UND-Glieder aufweisen, deren nicht miteinander in Reihe geschalteten Eingangsanschlüsse inverse Eingangsanschlüsse sind,
die Gatter-Sperrschaltungen für die erste, zweite und dritte Gatterschaltung (1, 2 bzw. 3) ein erstes, zweites bzw. drittes ODER-Glied (13, 14 bzw. 15) enthalten, die so angeordnet sind, daß sie Ausgangssignale der zweiten und der dritten Gatterschaltung (2, 3), Ausgangssignale der ersten und der dritten Gatterschaltung (1, 3) und Ausgangssignale der ersten und der zweiten Gatterschaltung (1, 2) aufnehmen,
die Gatter-Öffnungsschaltungen für die erste, zweite und dritte Gatterschaltung (1, 2 bzw. 3) ein erstes, zweites bzw. drittes UND-Glied (10, 11, 12) enthalten, die so angeordnet sind, daß sie individuell jeweils die zu ihnen rückgekoppelten Ausgangssignale der vierten bis sechsten Gatterschaltung (4, 5, 6) aufnehmen,
die Gatter-Halteschaltungen für die erste, zweite und dritte Gatterschaltung (1, 2 bzw. 3) ein viertes, fünftes bzw. sechstes UND-Glied (16, 17, 18) enthalten, die zur Zeit des Signaleingangs die Signale aus dem ersten, zweiten bzw. dritten ODER-Glied (13, 14 bzw. 15) unterbrechen,
das Ausgangssignal des ersten ODER-Glieds (13) und das invertierte Ausgangssignal der vierten Gatterschaltung (4) dem vierten UND-Glied (16) zugeführt werden, dessen Ausgangssignal invertiert und der ersten Gatterschaltung (1) zugeführt wird,
das Ausgangssignal des zweiten ODER-Glieds (14) und das invertierte Ausgangssignal der fünften Gatterschaltung (5) dem fünften UND-Glied (17) zugeführt werden, dessen Ausgangssignal invertiert und der zweiten Gatterschaltung (2) zugeführt wird,
das Ausgangssignal des dritten ODER-Glieds (15) und das invertierte Ausgangssignal der sechsten Gatterschaltung (6) dem sechsten UND-Glied (18) zugeführt werden, dessen Ausgangssignal invertiert und der dritten Gatterschaltung (3) zugeführt wird,
die vierte bis sechste Gatterschaltung (4, 5, 6) so angeordnet sind, daß ihren Eingangsanschlüssen mit Ausnahme derjenigen, die in Reihenschaltung miteinander verbunden sind, invertierte Eingangssignale zugeführt werden und diese invertierten Eingangssignale Ausgangssignale aus den anderen Zeilen und aus derselben Spalte sind,
und die Eingangsanschlüsse der ersten bis dritten Gatterschaltung (1, 2, 3) für die Aufnahme der Signale aus dem ersten, zweiten bzw. dritten ODER-Glied (13, 14, 15) invertierende Eingangsanschlüsse sind, die mit ihnen über das vierte, fünfte bzw. sechste UND-Glied (16, 17 bzw. 18) verbunden sind.

## Revendications

1. Circuit d'arbitrage, incorporé à un circuit intégré à semiconducteurs, pour accorder séquentiellement une priorité correcte à une pluralité de signaux de demande lors de l'apparition d'entrées concurrentes de tels signaux de demande sur N bornes d'entrée (où N est un entier égal ou supérieur à 3), le circuit d'arbitrage comportant :
N bornes d'entrée;
N bornes de sortie;
des circuits porte (1-6; 21-32) disposés pour former une matrice de N lignes et N-1 colonnes de telle manière que N-1 circuits porte sont reliés en série entre les N bornes d'entrée et de sortie, respectivement;
des circuits de maintien de porte (16-18; 49-56) agencés pour être commandés en réponse au passage d'un signal à travers un circuit porte quelconque et agissant pour maintenir, lors de l'achèvement de l'application dudit signal auxdits circuits porte, les autres signaux sur les circuits porte de la même ligne et de la ou des colonnes précédentes;
des circuits de fermeture de porte (13-15; 33-40) agencés pour être commandés en réponse au passage d'un signal à travers un circuit porte quelconque et agissant pour fermer, après achèvement de l'application dudit signal audit circuit porte, les circuits porte dans les autres lignes et la même colonne à l'exception du ou des circuits porte dans lesquels le signal est maintenu par le ou les circuits de maintien de porte; et
des circuits d'ouverture de porte (10-12; 41-48) agencés pour être commandés en réponse au passage d'un signal à travers un circuit porte quelconque et agissant pour ouvrir les circuits porte fermés dans les autres lignes et la colonne précédente.

2. Circuit d'arbitrage selon la revendication 1, comportant trois bornes d'entrée (a-c), trois bornes de sortie (d-f), et des circuits porte (1-6) disposés pour former une matrice à trois lignes et deux colonnes.

3. Circuit d'arbitrage selon la revendication 1 ou la revendication 2, dans lequel les circuits porte (1-6; 21-32), les circuits d'ouverture de porte (10-12; 41-48) et les circuits de maintien de porte (16-18; 49-56) comportent des circuits ET, et les circuits de fermeture de porte (13-15; 33-40) comportent des circuits OU.

4. Circuit d'arbitrage selon la revendication 2, dans lequel :
lesdits premier et quatrième circuits porte (1, 4) sont montés en série entre ladite première borne d'entrée (a) et ladite première borne de sortie (d);
lesdits second et cinquième circuits porte (2, 5) sont disposés en série entre ladite seconde borne d'entrée (b) et ladite seconde borne de sortie (e);
lesdits troisième et sixième circuits porte (3, 6) sont montés en série entre ladite troisième borne d'entrée (c) et ladite troisième borne de sortie (f);
les premier à sixième circuits porte (1-6) comportent des circuits ET dont les bornes d'entrée non reliées en série entre elles sont des bornes d'entrée d'inversion;
les circuits de fermeture de porte pour les premier à troisième circuits porte (1, 2, 3) comportent des premier à troisième circuits OU (13, 14, 15) disposés de manière à recevoir des signaux de sortie des second et troisième circuits porte (2, 3), des signaux de sortie des premier et troisième circuits porte (1, 3), et des signaux de sortie des premier et second circuits porte (1, 2), respectivement;
les circuits d'ouverture de porte pour les premier à troisième circuits porte (1, 2, 3) comportent des premier à troisième circuits ET (10, 11, 12) disposés de manière à recevoir individuellement les signaux de sortie des quatrième à sixième circuits porte (4, 5, 6) réappliqués à ceux-ci, respectivement;
les circuits de maintien de porte pour les premier à troisième circuits porte (1, 2, 3) comportent des quatrième à sixième circuits ET (16, 17, 18) agissant pour interrompre, à l'instant d'application du signal, des signaux provenant des premier à troisième circuits OU (13, 14, 15) respectivement;
une sortie du premier circuit OU (13) et une sortie inversée du quatrième circuit porte (4) sont appliquées au quatrième circuit ET (16), dont une sortie est inversée et appliquée au premier circuit porte (1);
une sortie du second circuit OU (14) et une sortie inversée du cinquième circuit porte (5) sont appliquées au cinquième circuit ET (17) dont une sortie est inversée et appliquée au second circuit porte (2);
une sortie du troisième circuit OU (15) et une sortie inversée du sixième circuit porte (6) sont appliquées au sixième circuit ET (18), dont une sortie est inversée et appliquée au troisième circuit porte (3);
les quatrième à sixième circuits porte (4, 5, 6) sont disposés de sorte que des signaux d'entrée inversés sont appliqués à leurs bornes d'entrée à l'exception de celles reliées en série entre elles, et ces signaux d'entrée inversés sont des signaux de sortie provenant des autres lignes et de la même colonne; et
des bornes d'entrée des premier à troisième circuits porte (1, 2, 3) pour recevoir les signaux, respectivement, des premier à troisième circuits OU (13, 14, 15) sont des bornes d'entrée avec inversion reliées à ceux-ci par l'intermédiaire des quatrième à sixième circuits ET (16, 17, 18).
